Europäisches Patentamt

(19) European Patent Office

Office européen des brevets

(11) Publication number : **0 489 600 A2**

(12) **EUROPEAN PATENT APPLICATION**

(21) Application number : **91311375.9**

(22) Date of filing : **06.12.91**

(51) Int. Cl.⁵ : **H01L 39/14**

(30) Priority : **06.12.90 JP 406329/90**

(43) Date of publication of application :
**10.06.92 Bulletin 92/24**

(84) Designated Contracting States :
**BE DE FR GB SE**

(71) Applicant : **NGK INSULATORS, LTD.**
**2-56, Suda-cho, Mizuho-ku**
**Nagoya City Aichi Pref. (JP)**

(72) Inventor : **Shimizu, Hideki, 205, NGK**
**Minamishataku, 15**
**Takedo-cho 2-chome, Mizuho-ku**
**Nagoya-City, Aichi pref. 467 (JP)**

(74) Representative : **Paget, Hugh Charles Edward**
**et al**
**MEWBURN ELLIS & CO. 2/3 Cursitor Street**
**London EC4A 1BQ (GB)**

(54) **Superconducting tubular material for magnetic shielding.**

(57)  A small tube (13) satisfying the following formula is fixed to the opening (for enabling the insertion of sensor, etc.) provided at the bottom or sidewall of a superconducting tubular material for magnetic shielding comprising a bottomed tubular substrate (20) and an oxide superconducting layer (21) formed on the substrate :

$$L/R \leqq L_1/R_1$$

wherein L is a distance from the top end of the tubular material to the small tube, i.e. the opening of the tubular material ; R is an inside diameter of the oxide superconducting layer in the tubular material ; $L_1$ is a length of the small tube ; and $R_1$ is an inside diameter of the oxide superconducting layer in the small tube. An oxide superconducting layer is formed on the small tube contiguously to the oxide superconducting layer (21) formed on the bottomed tubular substrate. The resulting superconducting tubular material for magnetic shielding restricts the penetration of a magnetic field into the tubular material through the opening.

# F I G. 4

## BACKGROUND OF THE INVENTION AND RELATED ART STATEMENT

The present invention relates to a superconducting bottomed tubular material for magnetic shielding, having excellent magnetic shielding properties. More particularly, the present invention relates to a superconducting tubular material for magnetic shielding, having, at the bottom or tubular portion, an opening or openings for enabling the insertion of sensor, etc.

A space surrounded by a ferromagnetic material such as Permalloy, ferrite or the like has heretofore been used for the purpose of magnetic shielding. Further, a number of magnetic shielding apparatuses utilizing the Meissner effect of superconducting materials (the research and development on superconducting materials are under way actively) have been proposed in recent years. For example, Japanese Patent Application Laid-Open No. 1-134998 proposes arranging a superconducting material in the innermost portion of a space to be shielded from magnetism. Also, the present applicant proposed, in Japanese Patent Application No. 1-97197, a magnetic shielding tube comprising at least two layers, i.e. a substrate and a superconducting layer arranged in this order viewed from the position of a magnetic source from which the tube should be shielded.

At the present moment, magnetic shielding tubular materials are still at a development stage. When a magnetic shielding tubular material is intended to be used in practical applications such as system for biomagnetism diagnosis, it is necessary to form an opening or openings at the bottom or the like of the tubular material for enabling the insertion of electric wire, sensor, etc. When such an opening or openings are formed, it is necessary to prevent the penetration of a magnetic field into the tubular material through the opening.

Hence, the present invention is intended to provide a superconducting bottomed tubular material for magnetic shielding which can prevent the penetration of a magnetic field into the tubular material through the opening formed in the material.

## SUMMARY OF THE INVENTION

According to the present invention, there is provided a superconducting tubular material for magnetic shielding comprising a bottomed tubular substrate having an opening at the bottom or the tubular portion, an oxide superconducting layer formed on the substrate, a small tube inserted into and fixed to the opening of the substrate, and an oxide superconducting layer formed on the small tube, wherein the small tube satisfies the following formula

$$L/R \leqq L_1/R_1$$

(L is a distance from the top end of the tubular material to the small tube, i.e. the opening of the tubular material; R is an inside diameter of the oxide superconducting layer in the tubular material; $L_1$ is a length of the small tube; and $R_1$ is an inside diameter of the oxide superconducting layer in the small tube) and the oxide superconducting layer on the small tube is formed contiguously to the oxide superconducting layer formed on the bottomed tubular substrate.

By a "small tube" is meant a tube of substantially smaller diameter ($R_1$) than the tubular material, e.g. less than one half diameter (R) or more preferably less than one quarter diameter R. Preferably $L \geqq 0.5 \, l$, where $l$ is the length of the tubular material.

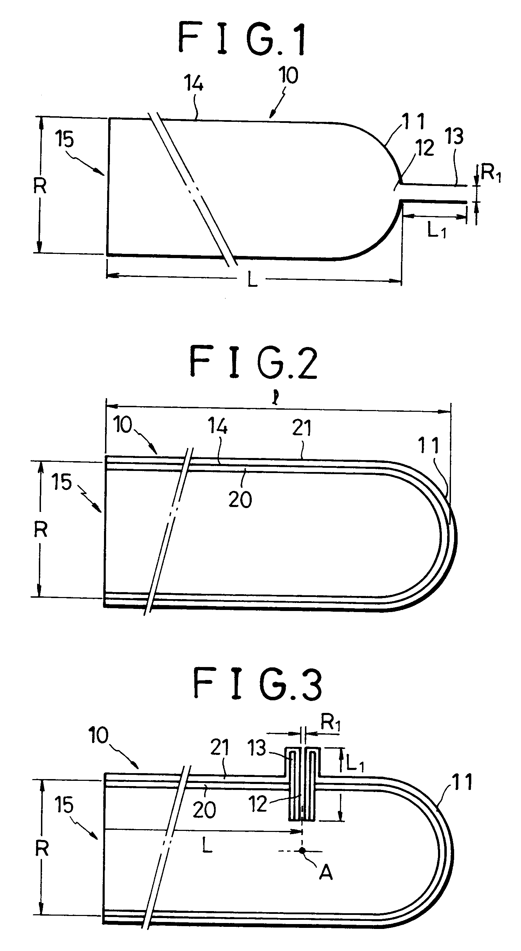

L of the above formula is defined more clearly for Fig. 3, when the point at which the central axis of the small tube 13 (i.e. the opening of the tubular substrate) intersects the central axis of the tubular material 1Ø, is named A, the distance from A to the top end 15 of the tubular material 1Ø is L.

## BRIEF DESCRIPTION OF THE DRAWINGS

Fig. 1 is an illustration showing an example of the superconducting tubular material for magnetic shielding according to the present invention.

Fig. 2 is an illustration showing an example of the superconducting tubular material for magnetic shielding comprising a bottomed tubular substrate and an oxide superconducting layer formed outside the substrate.

Fig. 3 is an illustration showing an example of the superconducting tubular material for magnetic shielding comprising a bottomed tubular substrate and an oxide superconducting layer formed outside the substrate.

Fig. 4 is an illustration showing an example of the superconducting tubular material for magnetic shielding comprising a bottomed tubular substrate and an oxide superconducting layer formed outside the substrate.

Fig. 5 is an illustration showing an example of the superconducting tubular material for magnetic shielding comprising a bottomed tubular substrate and an oxide superconducting layer formed outside the substrate.

Fig. 6 is an illustration showing an example of the superconducting tubular material for magnetic shielding comprising a bottomed tubular substrate and an oxide superconducting layer formed outside the substrate.

Fig. 7 is an illustration showing an example of the superconducting tubular material for magnetic shielding comprising a bottomed tubular substrate and an oxide superconducting layer formed inside the substrate.

Fig. 8 is an illustration showing an example of the superconducting tubular material for magnetic shielding comprising a bottomed tubular substrate and an oxide superconducting layer formed inside the substrate.

Fig. 9 is an illustration showing an example of the superconducting tubular material for magnetic shielding comprising a bottomed tubular substrate and an oxide superconducting layer formed inside the substrate.

Fig. 1∅ is an illustration showing an example of the superconducting tubular material for magnetic shielding comprising a bottomed tubular substrate and an oxide superconducting layer formed inside the substrate.

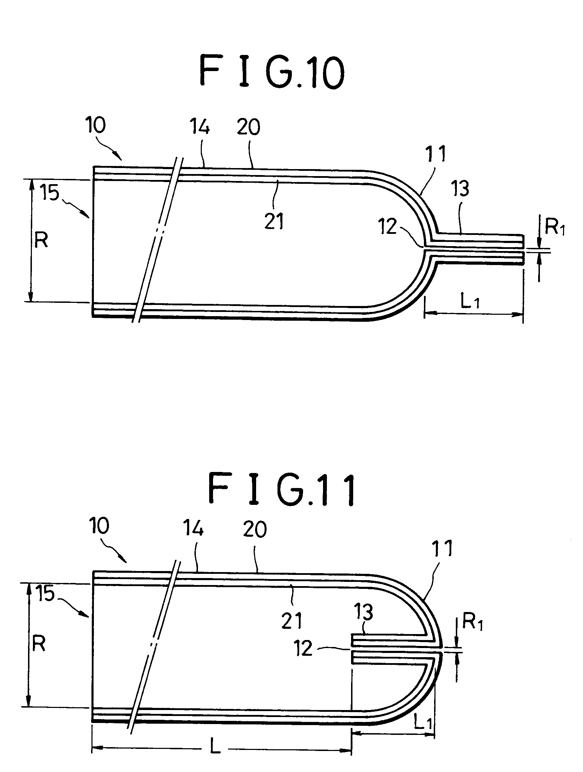

Fig. 11 is an illustration showing an example of the superconducting tubular material for magnetic shielding comprising a bottomed tubular substrate and an oxide superconducting layer formed inside the substrate.

## DETAILED DESCRIPTION OF PREFERRED EMBODIMENTS

The present inventors made experiments and investigations in order to find a means to prevent, in a superconducting tubular material for magnetic shielding, having an opening or openings for insertion of sensor, etc. at the bottom or the tubular portion close to the bottom, the penetration of a magnetic field into the tubular material through the opening. As a result, the present inventors found that in said superconducting tubular material for magnetic shielding, since the magnetic field incoming through the opening declines dependently upon Z/R as appreciated from the following formula (1), the penetration of the magnetic field through the opening can be prevented by fixing to the opening a small tube of a shape having a particular relation to the shape of the superconducting tubular material for magnetic shielding and then forming a superconducting layer on the small tube:

$$H \propto \exp(-k \times Z/R) \quad (1)$$

wherein H is an intensity of the magnetic field; k is a constant; Z is a distance from the opening, and R is an inside diameter of the cylindrical material for magnetic shielding.

That is, for example, in a superconducting tubular material 1∅ for magnetic shielding having an opening 12 at the bottom 11 as shown in Fig. 1, a small tube 13 satisfying the following formula (2) was fixed to the opening 12, and further an oxide superconducting layer was formed on the small tube 13 contiguously to the oxide superconducting layer of the tubular material 1∅; thereby, the penetration of a magnetic field into the tubular material 1∅ through the opening 12 could be sufficiently prevented:

$$L/R \leqq L_1/R_1 \quad (2)$$

wherein L is a distance from the top end 15 of the tubular material 1∅ to the small tube 13, i.e. the opening 12 of the tubular material 1∅; R is an inside diameter of the oxide superconducting layer in the tubular material 1∅; $L_1$ is a length of the small tube 13; and $R_1$ is an inside diameter of the oxide superconducting layer in the small tube 13.

Incidentally, the formula (2) can be rewritten to the following formula.

$$1.∅ \leqq (L_1/R_1)/(L/R)$$

More than one small tube 13 may be provided as long as the above formula is satisfied.

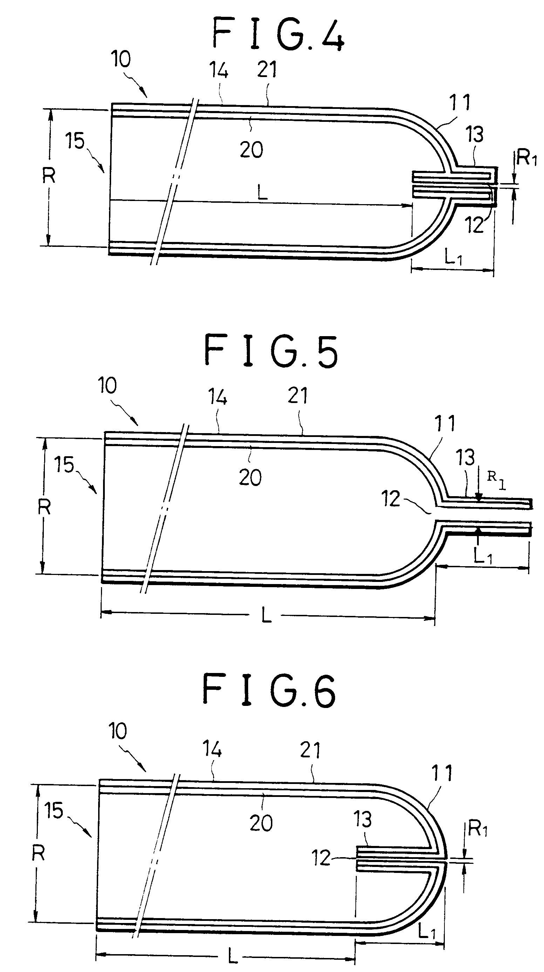

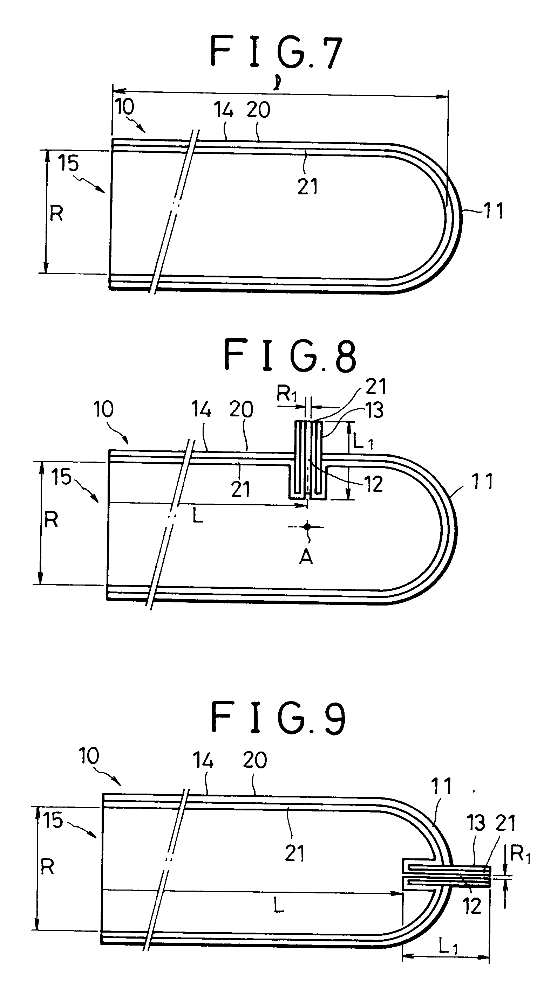

In the superconducting tubular material for magnetic shielding according to the present invention, the formation of the oxide supercondcuting layer may be on the inner surface, the outer surface, or both surfaces of the tubular substrate and on the inner surface, the outer surface, both surfaces or mostly on one surface and partly on both surfaces, of the small tube. The formation of the oxide superconducting layers on the tubular substrate and the small tube may be any combination of the above. For example, Figs. 3, 4, 5 and 6 each show a case where an oxide superconducting layer 21 has been formed on the outer surface of a bottomed tubular surface 2∅, and Figs. 8, 9, 1∅ and 11 each show a case where an oxide superconducting layer 21 has been formed on the inner surface of a bottomed tubular surface 2∅. In these figures, a small tube 13 of small diameter is inserted into the opening 12 formed at the bottom 11 or the tubular portion 14 of the superconducting tubular material 1∅ for magnetic shielding, in order to prevent the penetration of a magnetic field into the tubular material 1∅ through the opening 12. Importantly, at least one of the oxide superconducting layer(s) 21 formed on the outer surface and/or the inner surface of the small tube 13 must be contiguous to at least one of the oxide superconducting layer(s) 21 formed on the inner surface and/or the outer surface of the bottomed tubular substrate 2∅. Incidentally, Figs. 2 and 7 each show a case where no opening 12 is formed at any of the bottom 11 or the tubular portion 14.

The bottomed tubular substrate used for the superconducting tubular material for magnetic shielding of the present invention can be any as long as (a) it has no reactivity with the oxide superconducting layer formed thereon, (b) it can withstand a thermal shock when the superconducting tubular material is used in a magnetic shielding apparatus and subjected to a cold-hot cycle between an extremely low temperature (e.g. the boiling point of liquid nitrogen) and room temperature to exhibit superconducting properties, and (c) it can maintain the mechanical strengths of the oxide superconducting layer. There can be used, for example, ceramics and glasses of zirconia, titania, etc.; noble metals such as gold, silver, platinum and the like; and other metals such

as SUS 43∅, SUS 31∅, SUS 3∅4, Inconel, Incoloy, Hastelloy and the like. There can also be used laminates of these substances.

No particular restriction is imposed on the oxide superconducting layer. As the oxide superconducting layer, there can be preferably used, for example, rare earth type oxide superconducting materials represented by M-Ba-Cu-O compounds containing at least one rare earth element (M) selected from Sc, Y and lanthanide elements (e.g. La, Eu, Gd, Er, Yb, Lu), having a multi-layered perovskite structure and having a composition of, for example, $YBa_2Cu_3O_{7-y}$; and Bi type superconducting materials having a composition, for example, $Bi_2Sr_2Ca$-$Cu_2O_x$, $Bi_2Sr_2Ca_2Cu_3O_x$.

Next, description is made of one process for producing the superconducting tubular material for magnetic shielding of the present invention.

First, raw material oxides are mixed so as to give a composition of $Bi_2Sr_2CaCu_2O_x$ or $YBa_2Cu_3O_{7-y}$. The resulting mixture is calcined in the air at a predetermined temperature and then ground. The ground material is made into a slurry with a solvent. The slurry is coated, by spraying, dipping, brush or the like, on a bottomed tubular substrate having an opening at the bottom or at a predetermined position of the tubular portion, a small tube having been inserted into and fixed to said opening. Then, the composite comprising the bottomed tubular substrate and the oxide superconducting material is heated, for partial or complete melting of the oxide superconducting material, in an oxygen atmosphere at a temperature of 880-890°C when the oxide superconducting material is a Bi type and 980-1,100°C when the oxide superconducting material is an yttria type, for 30 minutes, and then is slowly cooled to give rise to crystallization, whereby the superconducting tubular material for magnetic shielding of the present invention can be produced.

In the above, the small tube is fixed to the tubular substrate in one piece. However, the small tube may be bonded by a superconducting material bonding technique after the oxide superconducting layer has been formed on the tubular substrate.

The present invention is hereinafter described in more detail by way of Examples. However, the present invention by no means restricted by these Examples.

## Examples 1-11 and Comparative Examples 1-5

There were prepared bottomed cylindrical substrates each having a small tube, of different shapes and dimensions as shown in the following Table 1 and Figs. 3, 4, 5 and 6. On each of these cylindrical substrates was coated, in a given thickness, a slurry obtained by calcining raw material oxides and then grinding the calcined product. Each of the coated substrates was fired in an oxygen atmosphere at 88∅-89∅°C for 3∅ minutes to prepare various oxide superconducting cylindrical materials for magnetic shielding.

Each of the bottomed cylindrical materials for magnetic shielding was evaluated as follows. The results are shown in Table 1.

## Evaluation

In a cylindrical material for magnetic shielding satisfying the following formula

$$\ell/R > 2.5$$

($\ell$ is a length of the cylindrical material, and R is an inside diameter of the oxide superconducting layer in the cylindrical material), when the magnetic field intensity outside the opening of the cylindrical material was expressed as Bo and the lowest magnetic intensity inside the cylindrical material was expressed as Bi, the cylindrical material was evaluated as ○(good) when Bi/Bo ≦ ∅.∅2 and as x (poor) when Bi/Bo > ∅.∅2.

Table 1

| | No. | Dimension (mm) | $\ell/R$ | Shape of opening | $L/R$ | $L_1/R_1$ | $(L_1/R_1)/(L/R)$ | Evaluation |
|---|---|---|---|---|---|---|---|---|
| Examples | 1 | $\phi150 \times 450^L$ | 3.0 | Fig.3 | 2.0 | 2.0 | 1.0 | ○ |
| | 2 | $\phi150 \times 450^L$ | 3.0 | Fig.3 | 2.5 | 2.5 | 1.0 | ○ |
| | 3 | $\phi150 \times 450^L$ | 3.0 | Fig.4 | 2.6 | 3.0 | 1.15 | ○ |
| | 4 | $\phi150 \times 450^L$ | 3.0 | Fig.5 | 3.0 | 3.0 | 1.0 | ○ |
| | 5 | $\phi150 \times 450^L$ | 3.0 | Fig.6 | 2.6 | 3.0 | 1.15 | ○ |
| | 6 | $\phi300 \times 750^L$ | 3.0 | Fig.5 | 3.0 | 3.0 | 1.0 | ○ |
| | 7 | $\phi500 \times 2000^L$ | 4.0 | Fig.5 | 4.0 | 4.0 | 1.0 | ○ |
| | 8 | $\phi650 \times 2000^L$ | 3.1 | Fig.5 | 3.1 | 3.5 | 1.13 | ○ |
| | 9 | $\phi1000 \times 3000^L$ | 3.0 | Fig.5 | 3.0 | 3.0 | 1.0 | ○ |
| | 10 | $\phi1000 \times 3000^L$ | 3.0 | Fig.6 | 2.8 | 3.0 | 1.07 | ○ |
| | 11 | $\phi1000 \times 3000^L$ | 3.0 | Fig.3 | 2.0 | 2.5 | 1.25 | ○ |
| Comparative Examples | 1 | $\phi150 \times 450^L$ | 3.0 | Fig.3 | 2.0 | 1.5 | 0.75 | × |
| | 2 | $\phi150 \times 450^L$ | 3.0 | Fig.4 | 3.0 | 0.0 | 0 | × |
| | 3 | $\phi150 \times 450^L$ | 3.0 | Fig.4 | 2.9 | 1.5 | 0.52 | × |
| | 4 | $\phi150 \times 450^L$ | 3.0 | Fig.5 | 3.0 | 1.0 | 0.33 | × |
| | 5 | $\phi150 \times 450^L$ | 3.0 | Fig.6 | 2.6 | 1.5 | 0.58 | × |

Notes: $\ell$ = length of cylindrical material

$L$ = distance from the top end of cylindrical material to small tube

$R$ = inside diameter of oxide superconducting layer in cylindrical material

$L_1$ = length of small tube

$R_1$ = inside diameter of oxide superconducting layer in small tube

As appreciated from Table 1, in superconducting bottomed tubular materials for magnetic shielding, the penetration of a magnetic field thereinto through the opening formed at the bottom or the tubular portion of the tubular material can be sufficiently prevented when a small tube of particular shape satisfying the following formula

$$1.\emptyset \leq (L_1/R_1)/(L/R)$$

is fixed to the opening and an oxide superconducting layer is coated on the small tube.

As stated above, the present invention can provide a superconducting tubular material for magnetic shielding having, at the bottom or the tubular portion, an opening or openings for enabling the insertion of sensor, etc., which can prevent the penetration of a magnetic field through the opening, by fixing a small tube of particular shape as mentioned above, to the opening and covering the small tube with a superconducting layer.

## Claims

1. A superconducting tubular material for magnetic shielding comprising a bottomed tubular substrate having an opening at the bottom or the tubular portion, an oxide superconducting layer formed on the substrate, a small tube inserted into and fixed to the opening of the substrate, and an oxide superconducting layer formed on the small tube, wherein the small tube satisfies the following formula

   $$L/R \leq L_1/R_1$$

   (L is a distance from the top end of the tubular material to the small tube; R is an inside diameter of the oxide superconducting layer in the tubular material; $L_1$ is a length of the small tube; and $R_1$ is an inside diameter of the oxide superconducting layer in the small tube) and the oxide superconducting layer on the small tube is formed contiguously to the oxide superconducting layer formed on the bottomed tubular substrate.

2. A tubular material according to Claim 1, wherein the oxide superconducting layer is formed outside the bottomed tubular substrate.

3. A tubular material according to Claim 1, wherein the oxide superconducting layer is formed inside the bottomed tubular substrate.

4. A tubular material according to Claim 1, wherein the oxide superconducting layer is formed inside and outside the bottomed tubular substrate.

5. A tubular material according to Claim 1, which satisfies the following formula

   $$\ell/R > 2.5$$

   wherein $\ell$ is a length of the tubular material and R is an inside diameter of the oxide superconducting layer in the tubular material.

EP 0 489 600 A2

# FIG.1

# FIG.2

# FIG.3

# F I G.4

# F I G.5

# F I G.6

# F I G.7

# F I G.8

# F I G.9

# F I G.10

# F I G.11